# EUROPEAN PATENT SPECIFICATION

(11) **EP 1 130 409 B1**
(45) Date of publication and mention of the grant of the patent: **09.11.2005**
(21) Application number: 01200044.4
(22) Date of filing: 09.01.2001
(51) Int. Cl.: G01R 31/3185

(54) **Boundary scan path method and system**
"Boundary Scan Path" Verfahren und System
Méthode et système de trajet "boundary scan"

(30) Priority: 10.01.2000 US 175188 P
(43) Date of publication of application: 05.09.2001
(73) Proprietor: TEXAS INSTRUMENTS INC., Dallas, Texas 75251 (US)
(72) Inventor: Whetsel, Lee D., Allen, Texas 72005 (US)
(74) Representative: Holt, Michael

(56) References cited:
- US-A- 5 715 254
- US-A- 5 862 152
- DERVISOGLU B ET AL: "SHARED I/O-CELL STRUCTURES: A FRAMEWORK FOR EXTENDING THE IEEE 1149.1 BOUNDARY-SCAN STANDARD" PROCEEDINGS OF THE INTERNATIONAL TEST CONFERENCE 1998. ITC '98. WASHINGTON, DC, OCT. 19 - 20, 1998, INTERNATIONAL TEST CONFERENCE, NEW YORK, NY: IEEE, US, vol. CONF. 29, 19 October 1998 (1998-10-19), pages 980-989, XP000822443 ISBN: 0-7803-5093-6

## Description

### Introduction

This disclosure describes a boundary scan system where memories, i.e. flip flops or latches, used in data scan cells are also used functionally, but memories used in control scan cells are dedicated for test and not used functionally. The control scan cells can be scanned while the circuit is in functional mode, since their memories are dedicated. However, the data scan cells can only be scanned after the circuit transitions into test mode, since their memories are shared. This boundary scan system advantageously provides; (1) lower test circuitry overhead since the data scan cells use shared memories, (2) safe entry into test mode since the control scan cells can be scanned during functional mode to pre-load safe control conditions, and (3) avoidance of floating (i.e. 3-state) busses that can cause high current situations.

In this context, the present invention provides apparatus and method as set fourth in the claims.

DERVISOGLU B ET AL: "SHARED I/O-CELL STRUCTURES: A FRAMEWORK FOR EXTENDING THE IEEE 1149.1 BOUNDARY-SCAN STANDARD" (PROCEEDINGS OF THE INTERNATIONAL TEST CONFERENCE 1998. WASHINGTON, DC, OCT. 19 - 20, 1998) discloses a Shared I/O Scan cell that allows functional storage elements to be used as part of the boundary-scan register. Test actions and functional operation of the IC is performed in a mutually exclusive fashion.

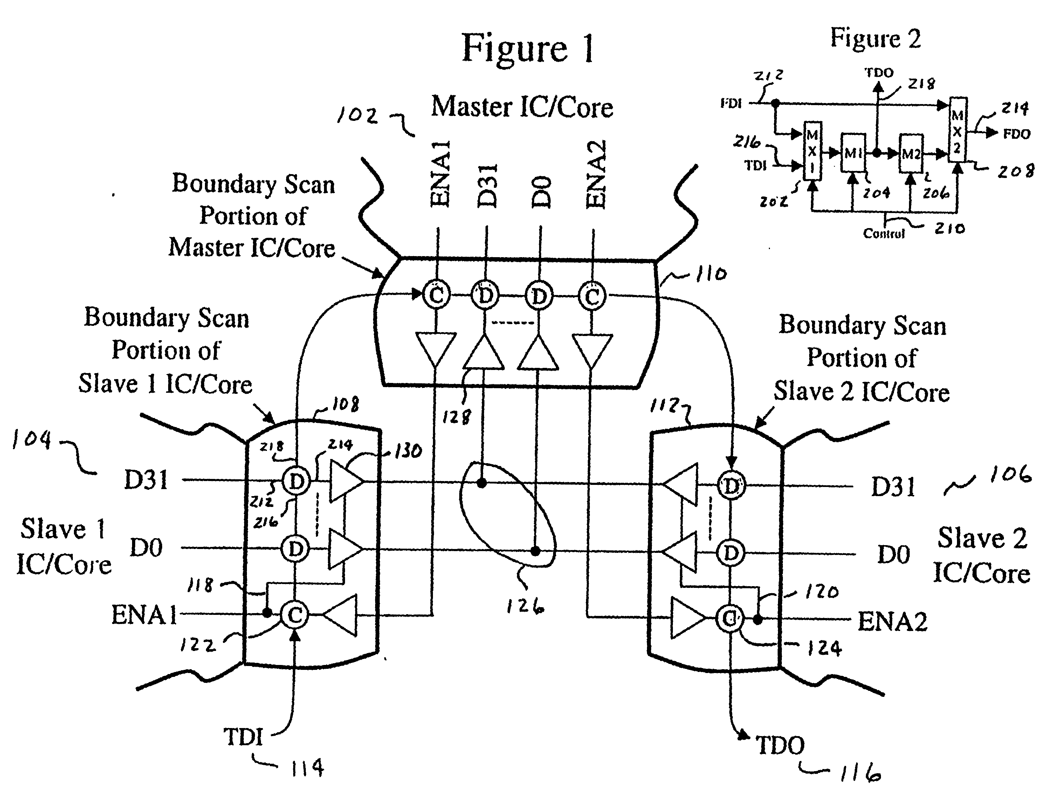

Figure 1 illustrates a prior art example of a dedicated boundary scan path or register existing around a master circuit 102, a slave 1 circuit 104, and a slave 2 circuit 106. The master circuit is a circuit that controls the slaves, such as a DSP, CPU, or micro-controller. The slave circuits are circuits being controlled by the master, such as RAM, ROM, cache, A/D, D/A, serial communication circuits, or I/O circuits. The master and slave circuits could exist as embedded core or sub-circuits inside an IC, or as individual ICs assembled on a board or multi-chip module (MCM). The scan paths 108-112 around each circuit are connected together serially and to a test data input (TDI) 114, which supplies test data to the scan paths, and a test data output (TDO) 116, which retrieves data from the scan paths. For simplification, only a portion of each circuits scan path 108-112 is shown. The scan paths of Figure 1 are designed using dedicated scan cells (indicated by darkened circles). The word dedicated means that the cell's circuitry is used for testing purposes and is not shared for functional purposes. The scan cells are located between the internal circuitry and the input 128 and output 130 buffers of the slaves and master circuit.

Figure 2 illustrates an example of a dedicated scan cell consisting of multiplexer 1 (MX1) 202, memory 1 (M1) 204, memory 2 (M2) 206, and multiplexer 1 (MX2) 208. This scan cell is similar to scan cells described in IEEE standard 1149.1, so only a brief description will be provided. During functional mode, functional data passes from the functional data input (FDI) 212 to the functional data output (FDO) 214. In functional mode, control inputs 210 to the scan cell can; (1) cause FDI data to be loaded into M1 via MX1 during a capture operation, (2) scanned from TDI 216 through MX1 and M1 to TDO 218 during a shift operation, and (3) data in M1 can be loaded into M2 during an update operation. Neither the capture, shift, nor update operation disturbs the functional data passing between FDI and FDO. Thus the scan cell of Figure 2 can be accessed and pre-loaded with test data while the cell is in functional mode. The data scan cell associated with the D31 output of slave 1 104 is labeled to indicate the FDI 212, TDI 216, FDO 214, and TDO 218 signal connections of the Figure 2 scan cell.

During functional mode of the circuit in Figure 1, data is transferred from one of the slaves to the master via the 32-bit data bus (D0-31). In functional mode the scan cells are transparent, allowing functional control and data signals to pass freely through the cells. In this example, the master enables slave 1 to transfer data by the ENA1 control signal, which is output from the master to slave 1. Likewise the master enables slave 2 to transfer data by the ENA2 control signal, which is output from the master to slave 2. While only two slave circuits are shown, any number could be similarly connected to and operated by the master. Since all the scan cells of the scan paths 108-112 are dedicated for test, they can be scanned from TDI to TDO without disturbing the functional mode of the Figure 1 circuit. As mentioned, being able to scan data into the scan paths during functional mode allows pre-loading an initial test pattern into the scan paths. The initial test pattern establishes both a data test pattern in the data scan cells (D) and a control test pattern in the control scan cells (C). By pre-loading an initial test pattern into the scan paths, the circuits can safely transition from a functioning mode to a test mode without concern over bus contention between the slave circuit's data busses. For example, the ENA1 122 and ENA2 124 control scan cells (C) can be pre-loaded with control data to insure that only one of the slave's D0-31 data busses is enabled to drive the wired bus connection 126. Maintaining output drive on one of the slave data busses upon entry into test mode prevents the wired data bus 126 from entering into a floating (i.e. 3-state) condition. Preventing bus 126 from floating is desirable since a floating input to input buffers 128 of master 102 could cause a high current condition.

When test mode is entered, functional operation of the master and slave circuits stop and the scan cells in the scan paths take control of the master and slave circuit's data and control signal paths. A data scan cell (D) exists on each of the 32-bit data signal paths of each circuit 102-106, and a control scan cell (C) exists on each of the ENA1 and ENA2 control paths of each circuit 102-106. Having dedicated data and control scan cells located as shown in Figure 1, enables safe test entry and easy interconnect testing of the wiring between the master and slave circuits when the scan paths are placed in test mode. During interconnect test mode, a capture, shift, and update control sequence, such as that defined in IEEE standard 1149.1, can be used to control the scan paths. To prevent contention between slave 1 and slave 2 data outputs 126 during the capture, shift, and update control sequence, the 3-state control outputs 118-120 of the ENA1 and ENA2 control scan cells 122-124 do not ripple during the capture and shift part of the control input sequence. This is accomplished by having the data in M2 of Figure 2 be output, via MX2, during the capture and shift operation. Only during the update part of the control input sequence are the outputs 118-120 of the control scan cells 122-124 allowed to change state by new data being loaded into M2. Similarly, the outputs from the data scan cells (D) do not ripple during capture and shift operations, but rather change state only during the update part of the control input sequence.

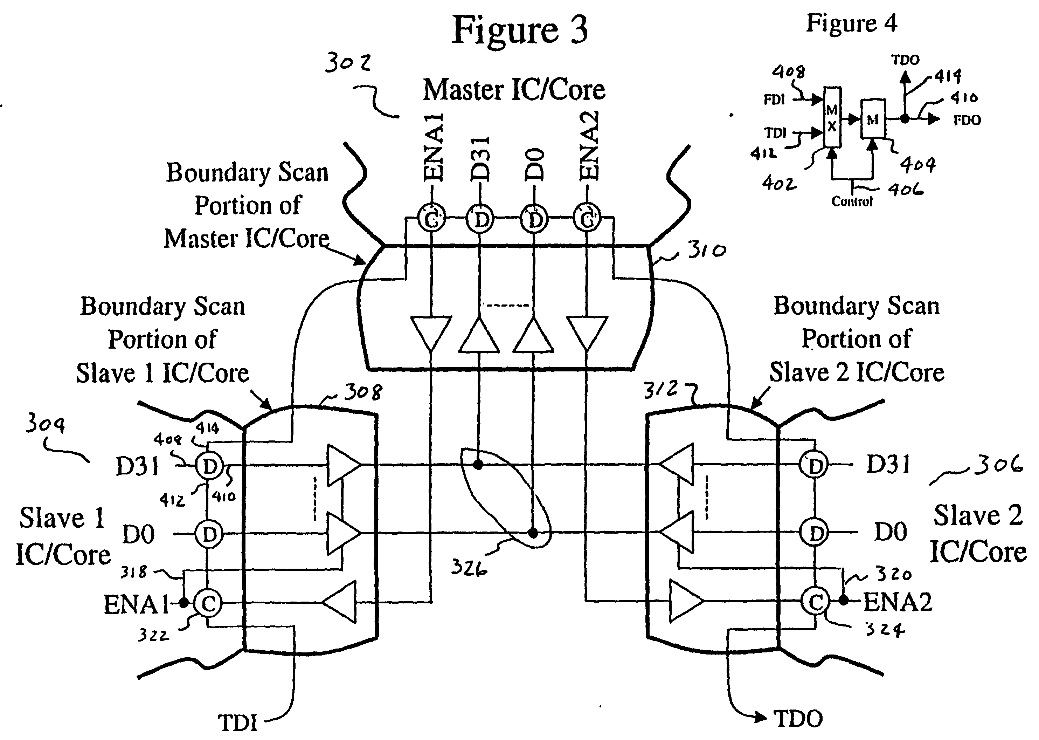

Figure 3 illustrates a prior art example of a shared boundary scan path existing around a master 302 and slave circuits 304-306. As in Figure 1, the scan paths 308-312 around each circuit are connected together serially and to a test data input (TDI), which supplies test data to the scan paths, and a test data output (TDO), which retrieves data from the scan paths. The scan paths of Figure 3 are designed using shared scan cells, i.e. the scan cell memory is shared for both test and functional purposes. As an aid to indicate use of shared scan cells as opposed to dedicated scan cells, the shared scan cells of Figure 3 and subsequent Figures are shown positioned outside the boundary scan paths 308-312, whereas the dedicated scan cells of Figure 1 were shown positioned inside the boundary scan paths 108-112. Again, for simplification, only a portion of each circuits boundary scan path is shown.

Figure 4 illustrates an example of a conventional shared scan cell consisting of a multiplexer (MX) 402 and a memory (M) 404. During functional mode, control inputs 406 form a path between FDI 408 and the data input of M 404 via MX 402, to allow functional data to be clocked from FDI to FDO 410. During test mode, the control inputs 406 cause FDI data to be clocked into M via MX during a capture operation, and cause test data to be clocked from TDI 412 to TDO 414 during a shift operation. Since M 404 is used functionally, it cannot be accessed and pre-loaded with test data as can the scan cell of Figure 2. Thus the ability to access and pre-load test data while the master and slave circuits of Figure 3 functionally operate is one of the key distinctions between dedicated (Figure 2) and shared (Figure 4) scan cells. The data scan cell associated with the D31 output of slave 1 304 is labeled to indicate the FDI 408, TDI 412, FDO 410, and TDO 414 signal connections of the Figure 4 scan cell.

During functional mode of the circuit in Figure 3, as in Figure 1, data is transferred from one of the slaves to the master via the 32-bit data bus (D0-31). The master enables data transfer from slave 1 or slave 2 via the ENA1 and ENA2 control signals, respectively. Since the scan cells of the scan paths are shared and used functionally, they cannot be scanned from TDI to TDO without disturbing the functional mode of the circuits. Not being able to scan data into the scan paths during functional mode prevents pre-loading an initial test pattern into the scan paths. By not being able to pre-load an initial test pattern into the scan paths, the slave circuits are put at risk of not safely transitioning into the test mode from the functional mode. This situation occurs due to the timing domains of the functional and test modes not being synchronous to one another, which results in asynchronous functional to test mode switching. For example, if the circuits of Figure 3 switched from the functional mode timing domain to a test mode timing domain, a possibility exists that the D0-31 output buffers of slave 1 and 2 could both be enabled as a result of an asynchronous mode switch that caused scan cell ENA1 322 and scan cell ENA2 324 to both output enable conditions on wires 318 and 320. This would force a voltage contention situation between slave 1 and 2, resulting in the output buffers being damaged or destroyed. This voltage contention situation does not occur in the boundary scan path of Figure 1 since an initial safe test pattern is pre-loaded into the scan cells prior to the functional to test mode switching step.

Once in test mode, the scan path of Figure 3 can be accessed to shift in test data. During shift operations the outputs 318-320 of the control scan cells 322-324 ripple as data shifts through the cells. This output ripple from the control scan cells can cause the D0-31 output buffers of the slaves to be enabled and disabled during the shift operation. This control output ripple causes the output buffers of slaves 1 and 2 to be simultaneously enabled, again creating bus contention between the slaves. This voltage contention situation does not occur in the boundary scan path of Figure 1 since M 206 maintains a safe control output, via MX 208, during shift operations.

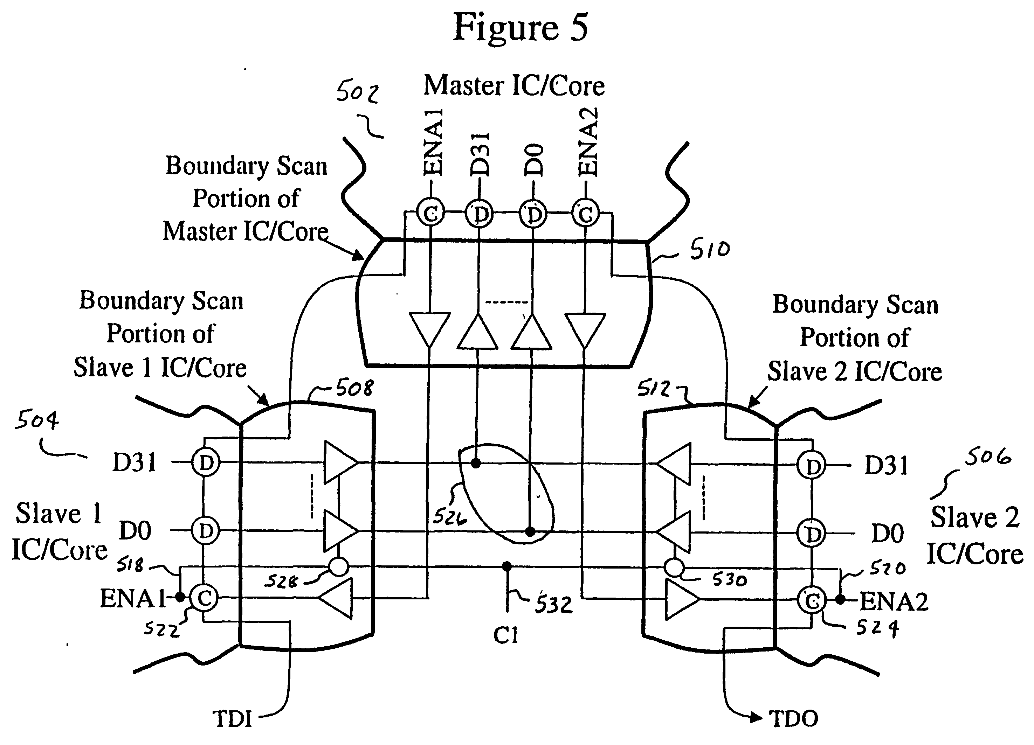

Figure 5 shows one prior art technique for preventing the above mentioned two voltage contention situations. The technique is based on providing additional circuitry and control inputs to enable or disable the slave's output buffers during test mode entry and again during each test mode shift operation. In Figure 5 a signal gating circuit 528 is inserted into signal path 518 of slave 504 and a signal gating circuit 530 is inserted into signal path 520 of slave 506. A control signal C1 532 is added as an input to circuits 528 and 530. When C1 is in a first state, the ENA1 and ENA2 outputs from scan cells 522 and 524 are allowed to pass through circuits 528 and 530 to enable or disable the output buffers of slaves 504 and 506. However, when C1 is in a second state, the outputs of circuits 528 and 530 are forced, independent of ENA1 and ENA2, to disable the output buffers of slaves 504 and 506. By controlling C1 to the second state during the transition from functional mode to test mode, the first above mentioned voltage contention situation can be avoided. By again controlling C1 to the second state during each shift operation that occurs during test mode, the second above mentioned voltage contention situation can be avoided.

While the technique described above solves the voltage contention situations, it does so by introducing a floating (i.e. 3-state) condition on data bus 526. As described above, the output buffers of slaves 504 and 506 are disabled during test mode entry and during each shift operation. With the output buffers disabled, data bus 526 is not driven and may float to a voltage level that could turn on both input transistors of the input buffers of master 502. This could result in a low impedance path between the master's supply and ground voltages, potentially damaging or destroying the input buffers of master 502.

Control for the multiplexers to select either the pathl's or path 2's between TDI and TDO come from a SEL signal which is connected to the select input of each multiplexer 636-640.

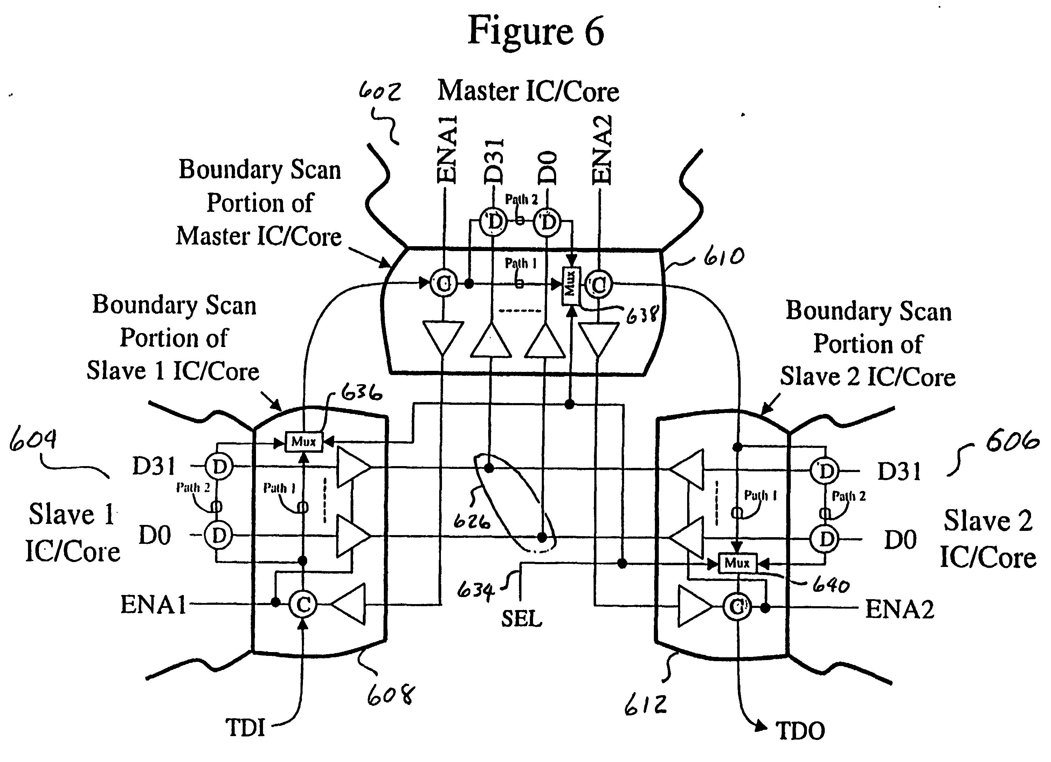

If the master and slave circuits and their associated boundary scan paths are realized as embedded cores within an IC, the SEL signal 634 may come from an IEEE 1149.1 instruction register on the IC, another register or circuit on the IC, or from an input pin on the IC. However, if the master and slave circuits and their associated boundary scan paths are realized as separate ICs on a board or MCM, the SEL signal may come from an IEEE 1149.1 instruction register on each of the ICs, another register or circuit on each of the ICs, or from an input pin on each of the ICs. In the case, where the master and slaves are separate ICs and where the SEL signal comes from an IEEE 1149.1 instruction register, or another register or circuit, on each IC, the SEL signal will not be bussed to the same wire 634 as shown in Figure 6, but rather individual SEL signal wires will exist between the IEEE 1149.1 instruction register, or another register or circuit, and multiplexers 636-64 on each of the individual ICs.

During functional mode of the circuit in Figure 6, as in Figures 1, 3, and 5 data is transferred from one of the slaves to the master via the 32-bit data bus (D0-31). The master enables data transfer from slave 1 or slave 2 via the ENA1 and ENA2 control signals, respectively. Since the data scan cells of the scan paths are shared and used functionally, they cannot be scanned from TDI to TDO without disturbing the functional mode of the circuits. However, since the control scan cells of the scan paths are not shared, they can be scanned from TDI to TDO without disturbing the functional mode of the circuit. By scanning the control scan cells by themselves, via path 1, it is possible to pre-load, while the master and slave circuits are functioning, a control test pattern into the control scan cells. This control test pattern can be advantageously used to establish the test mode state of the slave data busses to insure that no contention between the data busses occurs upon switching from functional mode to test mode. For example, a control test pattern may be scanned into the control scan cells via path 1 to, upon entry into test mode, enable slave 1's data bus and disable slave 2's data bus or to disable slave 1's data bus and enable slave 2's data bus. So, by designing the control scan cells as dedicated scan cells, and by selectively grouping only the control scan cells onto path1 between TDI and TDO, it is possible to pre-load a control test pattern to safely transition into test mode without slave bus contention and without disabling both slave buses.

When test mode is entered, functional operation of the circuits stop and the scan cells take control of the master and slave circuit's data and control signal paths. The state of the data scan cells will be unknown at the beginning of the test since they could not be scanned during functional mode. That is not a problem however since the known values scanned into the control scan cells prevent any contention on the data busses. After test mode is entered, the multiplexers 636-640 are controlled to group both the control and data scan cells onto path 2. A first combined data and control scan cell test pattern is then shifted into the scan path via path2 and updated to start the test. The outputs of the control scan cells of Figure 6 do not ripple during shift operations since they use the scan cell design of Figure 2, thus bus contention between slaves is prevented during shift operations. The outputs of the data scan cells do ripple during shift operation since they use the scan cell design of Figure 4. However, this data ripple does not harm the circuit or cause bus contention since only one slave is enabled at a time to output data onto bus 626. While only two slave circuits 604 and 606, each with an associated boundary scan portions 608 and 612, were shown in Figure 6, any number of slave circuits and associated boundary scan portions could be similarly connected to the master circuit 602 and associated boundary scan portion 610.

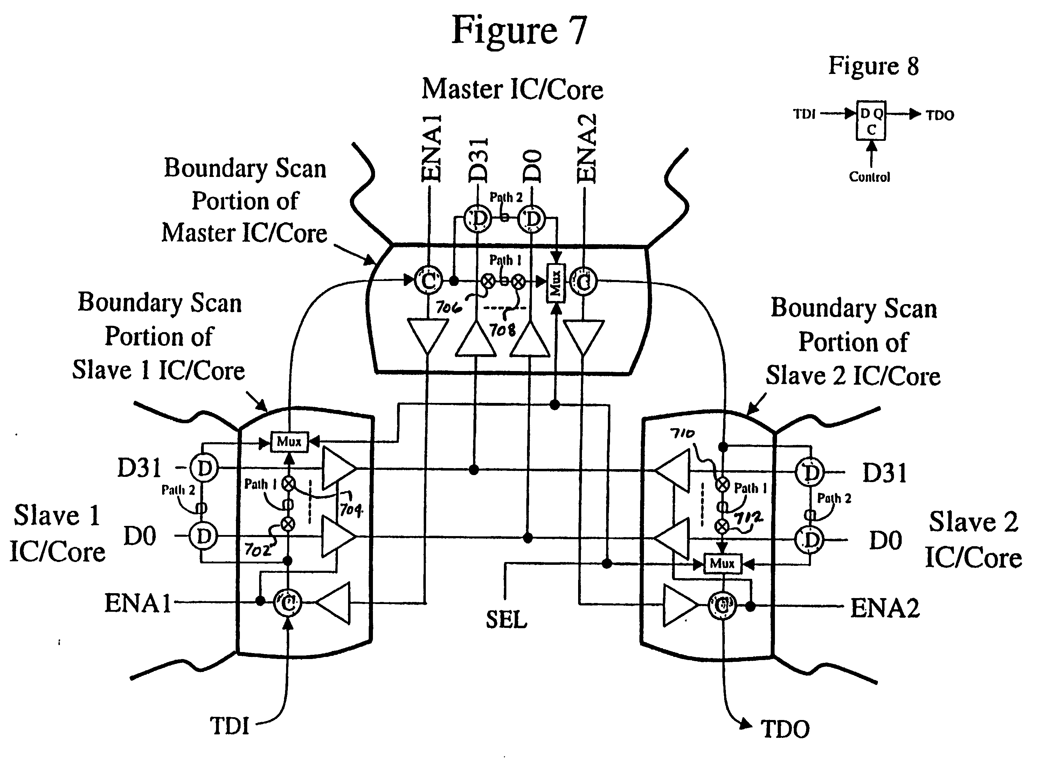

Figure 7 illustrates the boundary scan system of Figure 6 modified to include additional memories 702-712 in the path 1's. Depending upon the layout of the IC or core master and slave circuits, the wire runs between the scan inputs and outputs of the control scan cells in path 1 may become long when bypassing a large number of shared data scan cells. If the wiring becomes too long the setup and hold times of the control scan cells may be violated, resulting in shift operation failures through path 1. To prevent shift operation failures, one or more resynchronization memories 702-712 may be located in path 1 between the scan outputs and scan inputs of the control scan cells. The resynchronization memories, typically D flip flops as shown in Figure 8, would be located in scan path 1 such that the control data shifted through path 1 passes through a shorter length of wiring between the control scan cells and resynchronization memories, thus managing the setup and hold timing for reliably shifting data through path 1. If resynchronization memories are used, the bit length of path 1 will grow by the number of resynchronization memories. To compensate for this bit length growth, each test pattern shifted into path 1 will need to be augmented to include appropriately positioned resynchronization data bits during shift operations. As seen in Figure 7, the resynchronization memories 702-712 are not necessary when shift operations occur through path 2, since the shared data scan cells are not being bypassed. Thus scan path 2 does not include the resynchronization memories, and the test patterns shifted into scan path 2 advantageously do not need to be augmented to include the aforementioned resynchronization data bits.

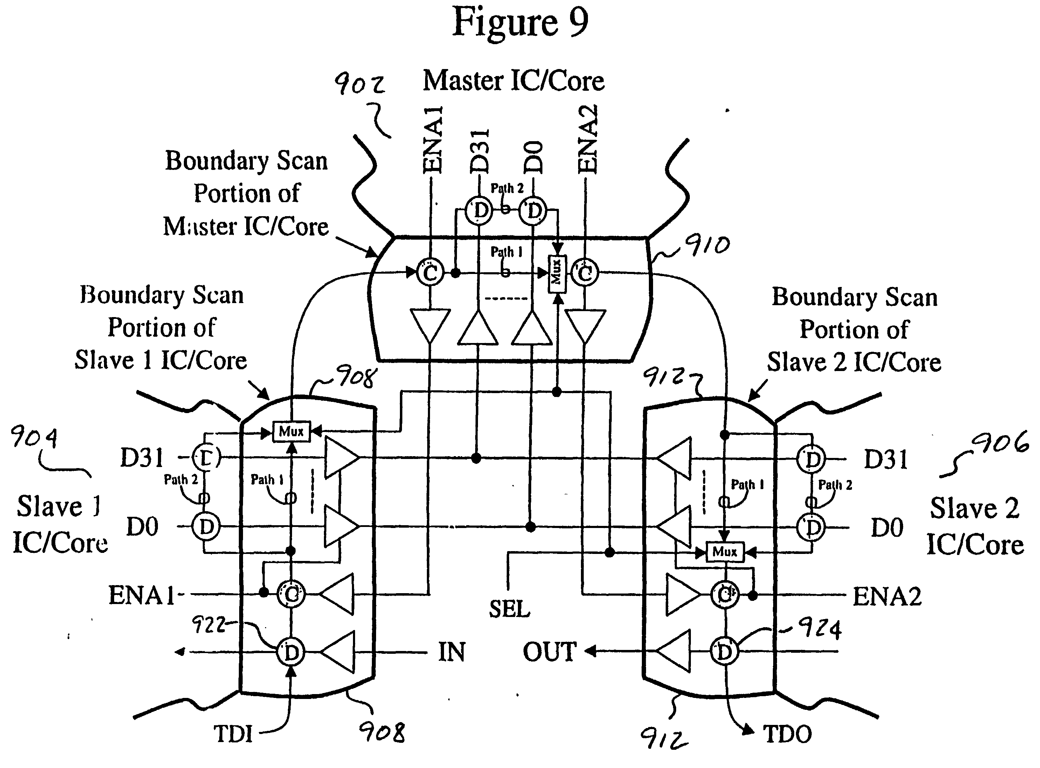

Figure 9 illustrates a boundary scan system consisting of master circuit 902 and slave circuits 904 and 906. Boundary scan portion 908 of slave 904 is similar to boundary scan portion 608 of Figure 6 with the exception that it includes an additional input (IN) to slave circuit 904 and an associated dedicated data scan cell 922. Also, boundary scan portion 912 of slave 906 is similar to boundary scan portion 612 of Figure 6 with the exception that it includes an additional output (OUT) from slave circuit 906 and an associated dedicated data scan cell 924. Figure 9 is included to indicate that dedicated data scan cells 922 and 924 (i.e. a scan cell similar to that of Figure 2) can be included in both path 1 and path 2 shift operations. When the path 1's are selected between TDI and TDO, data can be shifted through the control scan cells (C) and the 922 and 924 data scan cells (D) of Figure 9 during functional mode. When the path 2's are selected between TDI and TDO, data can be shifted through all the scan cells of Figure 9, both shared and dedicated, during test mode.

While specific signal types, i.e. data and control, have been associated with shared and dedicated scan cells in Figures 6 and 9, it should be understood that in general shared and dedicated scan cells are independent of signal types. What is important is to associate dedicated scan cells with signal types that need to be preconditioned with data prior to entry into test mode. Shared scan cells, on the other hand, can be associated with signal types that do not need to be preconditioned with data prior to test mode entry.

### Summary

Figures 6 and 9 and their accompanying descriptions have described a boundary scan path system consisting of groups of dedicated scan cells and groups of shared scan cells. Multiplexers within the boundary scan path system allow partitioning the boundary scan path to allow serial access to occur either to only the dedicated scan cell groups or to both the dedicated and shared scan cells groups. The ability to serially access dedicated scan cells within a boundary scan system independent of the shared scan cells, and while the functional circuits operate, advantageously allows loading certain key data signals which facilitate safe entry into test mode from the functional mode.

Figures 6 and 9 and their accompanying descriptions have also described a process for safely transitioning circuits and their associated boundary scans paths from their functional mode to test mode. The process can be summarized as: (1) configuring the boundary scan path system to contain only dedicated scan cells between TDI and TDO, (2) performing a shift operation to load data into the dedicated scan cells, (3) entering the boundary scan test mode, (4) configuring the boundary scan path system to contain all scan cells, both shared and dedicated, between TDI and TDO, and (5) performing a shift operation to load data into all the scan cells.

Figure 7 and its accompanying description has described why resynchronization memories may be needed and how they may be used to register data transfers across bypassed sections of shared scan cells to resolve setup and hold timing problems that might exist between a sending and receiving dedicated scan cell.

Although the present invention has been described in accordance to the embodiments shown in the figures, one of ordinary skill in the art will recognize there could be variations to these embodiments and those variations should be within the scope of the present invention.

## Claims

1. An integrated circuit comprising;
a test data input terminal and a test data output terminal;
a boundary scan path (608, 612) including one or more groups of serially connected dedicated boundary scan cells and one or more groups of serially connected shared boundary scan cells, said boundary scan path having an input and an output;
a first connection (path 1) formed between said test data input terminal and said boundary scan path input, and;
a second connection (path 2) formed between said test data output terminal and said boundary scan path output.

2. The integrated circuit of Claim 1 further comprising;
a multiplexer circuitry (636, 640) associated with said boundary scan path for selectively bypassing said one or more shared boundary scan cell groups such that only the one or more dedicated boundary scan cell groups exist between said input and output.

3. The integrated circuit of Claim 1 or Claim 2 further comprising;
at least one resynchronization memory (702, 712) located in the serial path between at least two of said dedicated boundary scan cell groups.

4. An integrated circuit as claimed in any preceding claim and wherein said scan path or a portion thereof is realized as part of or interfaced with an embedded core.

5. A process of entering into a boundary scan test mode comprising the steps of;
performing a first serial communication to load data into only a subset of the scan cells within the boundary scan path,
entering the boundary scan test mode, and;
performing a second serial communication to load data into all the scan cells within the boundary scan path.

## Patentansprüche

1. Integrierte Schaltung, mit:
einem Testdaten-Eingangsanschluss und einem Testdaten-Ausgangsanschluss;
einem Boundary-Scan-Pfad (608, 612), der eine oder mehrere Gruppen von in Reihe geschalteten, dedizierten Boundary-Scan-Zellen und eine oder mehrere Gruppen von in Reihe geschalteten gemeinsam genutzten Boundary-Scan-Zellen umfasst, wobei der Boundary-Scan-Pfad einen Eingang und einen Ausgang besitzt;
einer ersten Verbindung (path 1), die zwischen dem Testdaten-Eingangsanschluss und dem Boundary-Scan-Pfad-Eingang ausgebildet ist, und
einer zweiten Verbindung (path 2), der zwischen dem Testdaten-Ausgangsanschluss und dem Boundary-Scan-Pfad-Ausgang ausgebildet ist.

2. Integrierte Schaltung nach Anspruch 1, ferner mit:
einer Multiplexer-Schaltungsanordnung (636, 640), die dem Boundary-Scan-Pfad zugeordnet ist, um die eine oder die mehreren gemeinsam genutzten Gruppen von Boundary-Scan-Zellen wahlweise so umzuleiten, dass nur die eine oder die mehreren dedizierten Boundary-Scan-Zellengruppen zwischen dem Eingang und dem Ausgang vorhanden sind.

3. Integrierte Schaltung nach Anspruch 1 oder Anspruch 2, ferner mit:
wenigstens einem Neusynchronisationsspeicher (702, 712), der sich in der Reihenschaltung zwischen wenigstens zwei der Gruppen dedizierter Boundary-Scan-Zellen befindet.

4. Integrierte Schaltung nach einem vorhergehenden Anspruch, bei der der Scan-Pfad oder ein Abschnitt hiervon als Teil eines eingebetteten Kerns verwirklicht ist oder damit über eine Schnittstelle verbunden ist.

5. Verfahren zum Eintreten in eine Boundary-Scan-Testbetriebsart, das die folgenden Schritte umfasst:
Ausführen einer ersten seriellen Kommunikation, um Daten nur in eine Untermenge der Scan-Zellen in dem Boundary-Scan-Pfad zu laden,
Eintreten in die Boundary-Scan-Testbetriebsart und
Ausführen einer zweiten seriellen Kommunikation, um Daten in alle Scan-Zellen in dem Boundary-Scan-Pfad zu laden.

## Revendications

1. Circuit intégré comprenant :
une borne d'entrée de données de test et une borne de sortie de données de test;
un chemin d'accès par registre à décalage périphérique comportant un ou plusieurs groupes de registres à décalages périphériques dédiés et connectés en série et un ou plusieurs groupes de registres à décalages périphériques partagés et connectés en série, ledit chemin ayant une entrée et une sortie;
une première connexion (trajet 1) formée entre ladite borne d'entrée de données de test et ladite entrée de chemin d'accès; et
une seconde connexion (trajet 2) formée entre ladite borne de sortie de données de test et ladite sortie dudit chemin d'accès.

2. Circuit intégré selon la revendication 1, comprenant en outre :
un circuit multiplexeur (636,640) associé audit chemin d'accès par registre à décalage périphérique pour contourner sélectivement ledit un ou plusieurs groupes de registres à décalages périphériques partagés de telle sorte que seulement un ou plusieurs groupes de registres à décalages périphériques dédiés existent entre ladite entrée et ladite sortie.

3. Circuit intégré selon la revendication 1 ou la revendication 2, comprenant en outre :
au moins une mémoire de resynchronisation (702,712) située dans le chemin en série entre au moins deux desdits groupes de registres à décalages périphérique dédiés.

4. Circuit intégré selon l'une quelconque des revendications précédentes, dans lequel ledit chemin d'accès ou une partie de ce chemin est réalisé en tant que partie d'un noyau embarqué ou est relié par interface à ce dernier.

5. Procédé pour passer à un mode de test en série comprenant les étapes consistant à :
exécuter une première communication en série pour charger des données dans seulement un sous-ensemble des registres à décalages à l'intérieur du chemin d'accès par registre à décalage périphérique,
passer au mode de test en séries; et
exécuter une seconde communication série pour charger des données dans l'ensemble des registres à décalages à l'intérieur du chemin d'accès par registre à décalage périphérique.
